# EUROPÄISCHE PATENTSCHRIFT

(11) **EP 2 606 610 B1**
(45) Veröffentlichungstag und Bekanntmachung des Hinweises auf die Patenterteilung: **20.03.2019**
(21) Anmeldenummer: 11740917.7
(22) Anmeldetag: 04.08.2011
(51) Int. Cl.: H04L 12/40, G05B 19/042, H04L 29/12

(54) **VERFAHREN ZUR VERGABE VON TEILNEHMERADRESSEN AN BUSTEILNEHMER EINES BUSBASIERTEN STEUERUNGSSYSTEMS**
METHOD FOR ISSUING SUBSCRIBER ADDRESSES TO BUS SUBSCRIBERS OF A BUS-BASED CONTROL SYSTEM
PROCÉDÉ D'ATTRIBUTION D'ADRESSES D'ABONNÉS À UN ABONNÉ AU BUS D'UN SYSTÈME DE COMMANDE À BASE DE BUS

(30) Priorität: 19.08.2010 DE 102010035771
(43) Veröffentlichungstag der Anmeldung: 26.06.2013
(73) Patentinhaber: Pilz GmbH & Co. KG, 73760 Ostfildern (DE)
(72) Erfinder: GODAU, Thorsten, 73760 Ostfildern (DE); HAERTER, Michael, 73760 Ostfildern (DE); SEIZINGER, Dietmar, 73760 Ostfildern (DE); HAUEISEN, Reiner, 73760 Ostfildern (DE)
(74) Vertreter: Witte, Weller & Partner Patentanwälte mbB
(86) Internationale Anmeldenummer: PCT/EP2011/063416
(87) Internationale Veröffentlichungsnummer: WO 2012/022619

(56) Entgegenhaltungen:
- WO-A1-2004/095300
- WO-A1-2006/114314
- DE-A1-102008 060 007

## Beschreibung

Die vorliegende Erfindung betrifft ein Verfahren zur Vergabe von Teilnehmeradressen an Busteilnehmer eines busbasierten Steuerungssystems, insbesondere eines Steuerungssystems zum automatisierten Steuern eines technischen Prozesses, mit den Schritten:
- Bereitstellen einer Vielzahl von Busteilnehmern, die über ein Kommunikationsmedium miteinander verbunden werden,
- Zuweisen von logischen Teilnehmeradressen an die Busteilnehmer von einer zentralen Station aus, und
- Verifizieren der zugewiesenen logischen Teilnehmeradressen in der zentralen Station.

Die Erfindung betrifft ferner ein busbasiertes Steuerungssystem zum automatisierten Steuern eines technischen Prozesses, mit einer Vielzahl von Busteilnehmern, die über ein Kommunikationsmedium miteinander verbunden sind, wobei den Busteilnehmern logische Teilnehmeradressen zugewiesen sind, und mit einer Station, die dazu ausgebildet ist, die zugewiesenen logischen Teilnehmeradressen zu verifizieren.

Ein solches Verfahren und ein solches Steuerungssystem sind aus WO 2006/114314 A1 bekannt.

Ein Bussystem im Sinne der vorliegenden Erfindung ist ein Kommunikationsnetzwerk, das speziell dazu eingerichtet ist, eine Datenkommunikation zwischen einer Vielzahl von so genannten Busteilnehmern und ggf. einer zentralen Station zu ermöglichen. Typischerweise werden Bussysteme im Sinne der Erfindung eingesetzt, um eine insbesondere zyklische Datenkommunikation zwischen räumlich voneinander entfernten Steuergeräten und E/A-Geräten zu ermöglichen. Die E/A-Geräte besitzen Eingänge und/oder Ausgänge, über die Signale von abgesetzten Sensoren aufgenommen werden, bzw. abgesetzte Aktoren angesteuert werden. Steuergeräte verarbeiten Eingangsdaten, die den Signalen der Sensoren entsprechen, und erzeugen Ausgangsdaten, aus denen die E/A-Geräte die Ausgangssignale für die Aktoren erzeugen. Durch die Verwendung von Bussystemen ist es möglich, eine Vielzahl von Sensoren und Aktoren mit begrenztem Verkabelungsaufwand räumlich entfernt von einem oder mehreren Steuergeräten anzuordnen.

Es gibt zahlreiche Varianten von Bussystemen, die für verschiedene Anforderungen entwickelt wurden. In vielen Fällen benötigen die Busteilnehmer jeweils eine individuelle Teilnehmeradresse, damit die über das Kommunikationsmedium übertragenen Nachrichten dem gewünschten Empfänger zugeordnet werden können, und zum Teil auch, um den jeweiligen Absender der Nachricht zu identifizieren. Die Vergabe der Teilnehmeradressen erfolgt üblicherweise in einem Konfigurationsmodus vor der Inbetriebnahme des Bussystems.

Es sind verschiedene Verfahren zur Vergabe von Teilnehmeradressen bekannt. Eine Möglichkeit besteht darin, die einzelnen Busteilnehmer mit Adresswahlschaltern zu versehen, wobei die jeweilige Teilnehmeradresse am Busteilnehmer selbst mit Hilfe des jeweiligen Adresswahlschalters eingestellt wird. Eine solche Vorgehensweise besitzt den Nachteil, dass die Vergabe einer Teilnehmeradresse nur am Ort des jeweiligen Busteilnehmers möglich ist. Eine zentrale Konfiguration des Bussystems ist nicht möglich.

Es gibt daher zahlreiche Verfahren, mit denen Busteilnehmern eines Bussystems Adressen von einer zentralen Station aus über das Bussystem selbst zugewiesen werden können. Ein solches Verfahren ist beispielsweise in DE 197 33 906 A1 beschrieben. Die Adressvergabe beruht hier auf unterschiedlichen Entfernungen der Busteilnehmer von der so genannten Masterstation, die die Teilnehmeradressen vergibt, sowie auf den daraus resultierenden unterschiedlichen Nachrichtenlaufzeiten. Mit dem Verfahren wird einer Vielzahl von Busteilnehmern der Reihe nach jeweils eine individuelle Teilnehmeradresse zugeordnet. Das bekannte Verfahren eignet sich allerdings nicht für die Vergabe von Teilnehmeradressen in einem Bussystem, das zur Übertragung von sicherheitsrelevanten Daten im Sinne der europäischen Normen EN 954-1, IEC/EN 61508 oder EN ISO 13849-1 verwendet werden soll. Diese Normen definieren Anforderungen für die Gestaltung und Realisierung von Maschinen und Maschinenanlagen, von denen im Betrieb eine Gefahr für Personen ausgehen kann. Wenn über das Bussystem beispielsweise ein Freigabesignal von einem Not-Aus-Taster oder einer Sicherheitslichtschranke an eine Steuerung oder ein Abschaltsignal für einen elektrischen Antrieb übertragen werden soll, muss gewährleistet sein, dass die jeweiligen Nachrichten vom tatsächlichen Sender stammen und auch an den tatsächlichen Empfänger gelangen. Eine fehlerhafte Adresszuweisung kann fatale Folgen haben, wenn beispielsweise beim Unterbrechen einer Sicherheitslichtschranke eine falsche Maschine abgeschaltet wird und folglich eine gefährliche Maschine weiterläuft.

Für ein Bussystem, das zum Steuern von sicherheitsrelevanten Vorgängen im Sinne der zuvor genannten Normen verwendet werden soll, muss die Adressvergabe fehlersicher sein. Dabei bedeutet "fehlersicher" im Folgenden, dass zumindest die Anforderungen der Kategorie 3 der europäischen Norm EN 954-1 und/oder die Anforderungen gemäß SIL2 der IEC/EN 61508 oder vergleichbare Anforderungen erfüllt werden. Ein möglicher Fehler bei der Vergabe der Adressen darf demnach nicht dazu führen, dass die gesteuerte Anlage in einen Zustand gelangt, der eine Gefahr für einen Bediener oder eine andere Person darstellt.

DE 199 34 514 C1 offenbart ein Verfahren zur Vergabe von Teilnehmeradressen an Busteilnehmer eines Steuerungssystems, bei dem die einzelnen Busteilnehmer aufgrund der Struktur des Bussystems eine eindeutig definierte physikalische Position besitzen. Jeder Busteilnehmer verifiziert eine zugewiesene logische Adresse anhand seiner eindeutigen physikalischen Position. Das Verfahren eignet sich insbesondere zur Vergabe von Teilnehmeradressen an Busteilnehmer des so genannten Interbusses, der zur Automatisierung von technischen Prozessen in Produktionsumgebungen Verbreitung gefunden hat. Die Verifikation einer vergebenen Teilnehmeradresse anhand einer tatsächlichen physikalischen Position nutzt jedoch eine besondere Eigenschaft des Interbusses und ist daher nicht auf andere Bussysteme ohne diese besondere Eigenschaft übertragbar.

DE 199 40 874 A1 offenbart ein anderes Verfahren zum Konfigurieren eines Busteilnehmers für ein sicherheitsgerichtetes Steuerungssystem, wobei dem Busteilnehmer eine Teilnehmeradresse zugeordnet wird. In diesem Fall meldet sich ein noch nicht konfigurierter Busteilnehmer unter einer vordefinierten, eindeutig festgelegten Universaladresse bei einer zentralen Station an, die ebenfalls am Bussystem angeschlossen ist. Die zentrale Station weist dem neu angemeldeten Busteilnehmer eine Teilnehmeradresse zu, die durch einen nachfolgenden Datenverkehr zwischen dem Busteilnehmer und der Station verifiziert wird. Die zentrale Station überwacht dabei, dass jeweils nur genau ein Busteilnehmer konfiguriert wird. Dieses Verfahren eignet sich insbesondere, um einen einzelnen Busteilnehmer zu konfigurieren, der als Austauschgerät einen defekten Busteilnehmer am bereits konfigurierten Bussystem ersetzt. Wenn einer größeren Anzahl von Busteilnehmern Adressen zugewiesen werden sollen, ist dieses Verfahren jedoch recht zeitaufwändig.

Die eingangs genannte WO 2006/114314 A1 offenbart ein Verfahren zur Adressvergabe für sichere Teilnehmer eines Feldbusses, wobei dem sicheren Busteilnehmer eine definierte Teilnehmeradresse mit einer Adressvergabenachricht zugeordnet wird. Der Busteilnehmer versendet anschließend eine Bestätigungsnachricht an die übergeordnete Station, die die Adressvergabenachricht erzeugt hat. Die Station verifiziert die vergebene Adresse mit Hilfe der Bestätigungsnachricht.

WO 2004/095300 A1 beschreibt ein Verfahren zum Adressieren von Modulen eines Bussystems, bei dem ein Adresswert von einer übergeordneten Station von Modul zu Modul weitergegeben und bei jeder Weitergabe verändert wird. Insbesondere wird der Adresswert bei der Weitergabe inkrementiert. Wenn durch die Veränderung eine definierte Bedingung, etwa ein Overflow erfüllt ist, erzeugt dies ein Chip-Select-Signal, anhand dessen das Modul erkennen kann, dass die auf einer separaten Datenleitung übertragenen Daten für dieses Modul bestimmt sind. Dieses Verfahren ermöglicht daher eine Adressierung anhand der Position des Moduls sowie eine lokale Erkennung des Adressaten.

Vor diesem Hintergrund ist es eine Aufgabe der vorliegenden Erfindung, ein alternatives Verfahren zur fehlersicheren Vergabe von Teilnehmeradressen an Busteilnehmer eines Bussystems anzugeben. Es ist insbesondere eine Aufgabe, ein alternatives Verfahren anzugeben, das eine fehlersichere Verifikation für eine Vielzahl von Busteilnehmern im Rahmen einer Erstkonfiguration ermöglicht.

Gemäß einem Aspekt der Erfindung wird diese Aufgabe durch ein Verfahren der eingangs genannten Art gelöst, wobei die Busteilnehmer mit Hilfe einer definierten mathematischen Operation einen gemeinsamen ersten Prüfwert berechnen, der in der zentralen Station mit einem zweiten Prüfwert verglichen wird, um die zugewiesenen logischen Teilnehmeradressen zu verifizieren, wobei die mathematische Operation mit einem definierten Startwert beginnt und eine Anzahl von Operationsschritten beinhaltet, die eine Anzahl von definierten Operanden verwenden, wobei jede der zu verifizierenden Teilnehmeradressen einen anderen Operanden bildet, wobei jeder Busteilnehmer zumindest einen Operationsschritt durchführt wobei die zentrale Station über das Kommunikationsmedium mit den Busteilnehmern verbunden ist und den gemeinsamen ersten Prüfwert über das Kommunikationsmedium erhält, und wobei die zentrale Station den zweiten Prüfwert unabhängig von den Busteilnehmern mit derselben mathematischen Operation, demselben Startwert und denselben Operanden berechnet.

Gemäß einem weiteren Aspekt der Erfindung wird diese Aufgabe durch ein Steuerungssystem der eingangs genannten Art gelöst, wobei die Busteilnehmer dazu ausgebildet sind, mit Hilfe einer definierten mathematischen Operation einen gemeinsamen ersten Prüfwert zu berechnen, der in der Station mit einem zweiten Prüfwert verglichen wird, um die zugewiesenen logischen Teilnehmeradressen zu verifizieren, wobei die mathematische Operation mit einem definierten Startwert beginnt und eine Anzahl von Operationsschritten beinhaltet, die eine Anzahl von definierten Operanden verwendet, wobei jede der zu verifizierenden Teilnehmeradressen einen anderen Operanden bildet, wobei jeder Busteilnehmer dazu ausgebildet ist, zumindest einen Operationsschritt durchzuführen, wobei die Station über das Kommunikationsmedium mit den Busteilnehmern verbunden ist und den gemeinsamen ersten Prüfwert über das Kommunikationsmedium erhält, und wobei die Station den zweiten Prüfwert unabhängig von den Busteilnehmern mit derselben mathematischen Operation, demselben Startwert und denselben Operanden berechnet.

Vorzugsweise ist die Station eine Steuereinheit des Steuerungssystems, und die Busteilnehmer sind E/A-Einheiten, die mit der Steuereinheit Daten austauschen, welche Eingangssignale von Sensoren und Ausgangssignale für Aktoren repräsentieren.

Das neue Verfahren und das neue Steuerungssystem verwenden einen definierten mathematischen Algorithmus, mit dessen Hilfe ein erster Prüfwert in mehreren sequentiell aufeinanderfolgenden Operationsschritten berechnet wird. Der erste Prüfwert hängt von allen zu verifizierenden Teilnehmeradressen ab und wird in separaten Teilschritten von allen Busteilnehmern, denen eine zu verifizierende Teilnehmeradresse zugewiesen wurde, gemeinsam berechnet. Vorzugsweise "kennt" jeder Busteilnehmer nur genau denjenigen Operationsschritt (oder diejenigen Operationsschritte) der mathematischen Operation, den der Busteilnehmer im Rahmen der räumlich verteilten Operationsschritte durchführen muss. Mit anderen Worten ist es bevorzugt, wenn kein Busteilnehmer (abgesehen von der Station, die die Teilnehmeradressen verifiziert) die Gesamtheit der Operationsschritte und/oder Operanden kennt, die für die Verifikation verwendet werden. In diesem Fall werden nämlich zwingend alle Busteilnehmer für die Verifikation benötigt.

Es ist ferner bevorzugt, wenn der erste Prüfwert ein Zahlenwert ist, der sich aus den vergebenen Teilnehmeradressen eindeutig ergibt, d.h. das Ergebnis der mathematischen Operation liefert zu jeder Kombination von Teilnehmeradressen genau einen individuellen Prüfwert.

Das neue Verfahren und das neue Steuerungssystem ermöglichen eine schnelle und zuverlässige Überprüfung der Adresszuweisung. Es kann eine beliebig große Anzahl von Teilnehmeradressen in einem Verifikationsdurchlauf überprüft werden. Daher ermöglichen das neue Verfahren und das neue Bussystem eine Konfiguration von mehreren Busteilnehmern in einem Konfigurationsdurchlauf. Das neue Verfahren und das neue Steuerungssystem sind darüber hinaus weitgehend unabhängig von der physikalischen Struktur des Bussystems. Insbesondere kann das neue Verfahren bei Bussystemen verwendet werden, bei denen die tatsächliche physikalische Position der einzelnen Busteilnehmer am Kommunikationsmedium unbekannt ist oder nicht eindeutig bestimmt werden kann. Das neue Verfahren kann zudem in Fällen verwendet werden, in denen die Teilnehmeradressen in einer beliebigen Reihenfolge und/oder Struktur an die einzelnen Busteilnehmer vergeben werden, so dass keine nennenswerten Einschränkungen in Bezug auf die zu vergebenden Adressen bestehen.

Andererseits bieten das neue Verfahren und das neue Steuerungssystem den Vorteil, dass Teilnehmeradressen über das Bussystem selbst in einer fehlersicheren Art und Weise vergeben und verifiziert werden können. Die oben genannte Aufgabe ist daher vollständig gelöst.

In einer bevorzugten Ausgestaltung der Erfindung führt jeder Busteilnehmer (zumindest) einen Operationsschritt durch, in dem die dem Busteilnehmer zugewiesene Teilnehmeradresse den Operand bildet.

In dieser Ausgestaltung berechnet jeder Busteilnehmer "seinen" Operationsschritt mit "seiner" Teilnehmeradresse. Alternativ ist es in anderen Ausgestaltungen der Erfindung möglich, dass die Busteilnehmer die verteilten Operationsschritte mit jeweils "fremden" Teilnehmeradressen durchführen, d.h. jeder Busteilnehmer berechnet einen Operationsschritt mit einer Teilnehmeradresse, die einem anderen Busteilnehmer zugewiesen ist. In der bevorzugten Ausgestaltung kann die Verifikation jedoch einfacher und schneller durchgeführt werden, da die einzelnen Busteilnehmer die ihnen zugewiesene Teilnehmeradresse bereits kennen. In beiden Varianten ist die Anzahl der Operationsschritte zumindest gleich der Anzahl von Busteilnehmern.

In bevorzugten Varianten ist die zentrale Station ein so genannter Busmaster, d.h. ein Busteilnehmer, der im Vergleich zu den anderen Busteilnehmern über besondere Rechte und/oder Fähigkeiten verfügt. Typischerweise steuert und/oder organisiert der Busmaster die Kommunikation der Busteilnehmer über das Kommunikationsmedium, indem er beispielsweise Kommunikationszyklen initiiert, Zeitschlitze und/oder Datenfelder für die Daten der einzelnen Busteilnehmer bereitstellt und/oder auf andere Weise eine Arbitrierung gewährleistet. Die Ausgestaltung besitzt den Vorteil, dass die Adressvergabe am Bussystem selbst möglich ist. Die Implementierung der Funktion der zentralen Station in einem Busmaster ist darüber hinaus von Vorteil, weil ein Busmaster typischerweise nur einmal am Bussystem vorhanden ist und im Vergleich zu anderen Busteilnehmern häufig eine höhere Intelligenz und/oder Rechenleistung bereitstellt. Die Funktion der zentralen Station kann daher in einem Busmaster recht kostengünstig und effizient untergebracht werden.

In einer weiteren Ausgestaltung ist die zentrale Station fehlersicher ausgebildet.

Wie bereits weiter oben angedeutet, bedeutet "fehlersicher", dass zumindest eine Einfehlersicherheit gemäß Kategorie 3 der EN 954-1 oder vergleichbare Anforderungen erfüllt werden. Die Sicherheit des Systems darf trotz Auftreten eines Fehlers nicht verloren gehen. Typischerweise ist die zentrale Station in dieser Ausgestaltung mehrkanalig-redundant, um die Einfehlersicherheit zu erreichen. Es mag jedoch auch einkanalige Realisierungen geben, die die genannten Anforderungen erfüllen. Besonders bevorzugt ist es ferner, wenn die (weiteren) Busteilnehmer, denen Teilnehmeradressen zugewiesen werden, nicht-fehlersicher aufgebaut sind, da das neue Verfahren gemäß dieser Ausgestaltung auch in solchen Fällen eine fehlersichere Vergabe von Teilnehmeradressen ermöglicht. Die Ausgestaltung ist besonders vorteilhaft, wenn die zentrale Station als Busmaster am Bussystem fungiert, weil dann lediglich eine intelligente, fehlersichere Station benötigt wird und die weiteren Busteilnehmer vergleichsweise einfach und kostengünstig realisiert werden können.

In einer weiteren Ausgestaltung werden die Busteilnehmer in einer logischen Reihenfolge über das Kommunikationsmedium verbunden, wobei die logische Reihenfolge einen ersten Busteilnehmer, zumindest einen zweiten Busteilnehmer und einen letzten Busteilnehmer aufweist.

In einigen bevorzugten Ausführungsbeispielen entspricht die logische Reihenfolge der Busteilnehmer der Reihenfolge von Daten in einem vordefinierten Datenrahmen, der von den Busteilnehmern nach Art einer Eimerkette weitergeleitet wird, um die Kommunikation der Busteilnehmer untereinander und/oder mit dem Busmaster zu ermöglichen. In besonders bevorzugten Ausführungsbeispielen erzeugt der Busmaster einen solchen Datenrahmen in definierten, wiederholten Zeitintervallen. Der Datenrahmen wird von den Busteilnehmern der Reihe nach weitergeleitet, bis er zuletzt wieder zum Busmaster gelangt.

In dieser Ausgestaltung eignet sich das Bussystem besonders zum Einsammeln von Eingangsdaten, die Sensorsignale einer Vielzahl von Sensoren repräsentieren, und zum Ausgeben von Steuerbefehlen an die Aktoren eines verteilten Steuerungssystems. Die logische Reihenfolge der Busteilnehmer ermöglicht determinierte Zykluszeiten sowie eine einfache und kostengünstige Realisierung. Darüber hinaus eignet sich ein solches Bussystem sehr gut zur automatisierten Vergabe von Teilnehmeradressen, wobei das neue Verfahren zur Verifikation der vergebenen Adressen vorteilhaft eingesetzt werden kann. Besonders vorteilhaft ist es in diesem Fall, wenn eine mathematischen Operation nicht das Assoziativgesetz erfüllt, weil dann nicht nur die vergebenen Teilnehmeradressen, sondern auch die Reihenfolge der Busteilnehmer verifiziert werden, wie weiter unten anhand eines Ausführungsbeispiels erläutert ist.

In einer weiteren Ausgestaltung führt der erste Busteilnehmer einen ersten Operationsschritt durch, der den Startwert und einen ersten Operanden verwendet, um einen ersten Zwischenwert zu bestimmen, wobei der erste Busteilnehmer den ersten Zwischenwert an den zweiten Busteilnehmer sendet, und wobei der zweite Busteilnehmer einen zweiten Operationsschritt durchführt, in dem der erste Zwischenwert und ein zweiter Operand verwendet werden, um einen zweiten Zwischenwert zu bestimmen. Vorzugsweise führt der letzte Busteilnehmer einen letzten Operationsschritt durch, wobei der zweite Zwischenwert und ein letzter Operand verwendet werden.

In dieser Ausgestaltung berechnen die Busteilnehmer den ersten Prüfwert in derselben logischen Reihenfolge, in der sie über das Kommunikationsmedium miteinander verbunden sind. Aufgrund der vergebenen Teilnehmeradressen kann die logische Reihenfolge von der physischen Struktur, in der die Busteilnehmer an das Kommunikationsmedium angeschlossen sind, abweichen. Die logische Reihenfolge kann jedoch auch mit der physischen Struktur identisch sein. Die Ausgestaltung ermöglicht eine sehr einfache und kostengünstige Realisierung des neuen Verfahrens, und sie ermöglicht eine sehr schnelle Verifikation der vergebenen Teilnehmeradressen, da die Zwischenwerte jeweils direkt zur Weiterverwendung an den nachfolgenden Busteilnehmer gesendet werden.

In einer weiteren Ausgestaltung berechnet der letzte Busteilnehmer den gemeinsamen ersten Prüfwert mit dem letzten Operationsschritt. Alternativ hierzu ist es in einer anderen Ausgestaltung möglich, dass der letzte Busteilnehmer mit dem letzten Operationsschritt einen weiteren Zwischenwert bestimmt, mit dem der erste Prüfwert in weiteren Operationsschritten berechnet wird.

Die zuerst genannte Ausgestaltung besitzt den Vorteil, dass der erste Prüfwert nach einer geringen Anzahl von Operationsschritten schnell zur Verfügung steht. Die Verifikation der Teilnehmeradressen kann dementsprechend schnell erfolgen. Die zuletzt genannte Ausgestaltung besitzt demgegenüber den Vorteil, dass der erste Prüfwert weitere Prüfschritte und/oder Berechnungsschritte beinhalten kann. Dies kann einerseits vorteilhaft dazu verwendet werden, weitere Konfigurationsdaten des Bussystems, die unabhängig von den einzelnen Busteilnehmern sind, zu verifizieren. Andererseits kann der erste Prüfwert vorteilhaft in einer Weise aufbereitet und/oder verändert werden, die den Vergleich mit dem zweiten Prüfwert erleichtert.

In einer weiteren Ausgestaltung werden die Operationsschritte in einer definierten Reihenfolge von Operationsschritten durchgeführt, wobei der erste Prüfwert in Abhängigkeit von der definierten Reihenfolge von Operationsschritten variiert.

In dieser Ausgestaltung liefert die mathematische Operation abhängig von der Reihenfolge der durchgeführten Operationsschritte unterschiedliche Ergebnisse, selbst wenn der Startwert und die Operanden jeweils gleich sind. Bevorzugt wird eine mathematische Operation gewählt, die weder das Assoziativgesetz noch das Kommutativgesetz erfüllt. Die Ausgestaltung besitzt den bereits weiter oben angedeuteten Vorteil, dass nicht nur die vergebenen Teilnehmeradressen, sondern auch die Reihenfolge der Busteilnehmer selbst verifiziert werden. Dies ist besonders vorteilhaft, wenn das Bussystem zum Übertragen von sicherheitskritischen Daten verwendet wird, da eine Vertauschung von zwei typgleichen Teilnehmern einerseits schwer zu erkennen ist, andererseits aber leicht passieren und zu schwerwiegenden Folgen führen kann.

In einer weiteren Ausgestaltung ist die mathematische Operation eine Prüfsummenberechnung, insbesondere eine CRC-Prüfsummenberechnung, die auf einer Polynomdivision beruht. In besonders bevorzugten Ausführungsbeispielen ist die mathematische Operation eine CRC-8-, eine CRC-16- oder eine CRC-32-Prüfsummenberechnung.

Die Abkürzung CRC steht für *cyclic redundancy check.* Es handelt sich hier um ein definiertes Verfahren zum Berechnen eines Prüfwertes für Daten. Üblicherweise werden CRC-Prüfsummen berechnet, um Fehler bei der Übertragung oder Speicherung von Daten erkennen zu können. In der Regel wird die berechnete CRC-Prüfsumme dabei zusammen mit den abgesicherten Daten übertragen oder gespeichert. In der vorliegenden Ausgestaltung wird derselbe Algorithmus verwendet, um nach erfolgter Datenübertragung, nämlich nach der Vergabe der Teilnehmeradressen, in einem separaten Verifikationsschritt eine Prüfsumme zu berechnen, die den Erfolg der Adressvergabe überprüfbar macht. Die Verwendung des CRC-Algorithmus ermöglicht eine sehr kostengünstige und fehlersichere Realisierung. Je nach Anzahl und Länge der vergebenen Teilnehmeradressen ist es von Vorteil, eine kürzere oder längere Prüfsumme (CRC-8, CRC-16, CRC-32 etc.) zu verwenden.

In einer weiteren Ausgestaltung wird das Steuerungssystem nach einer erfolgreichen Verifikation in Betrieb genommen, wobei der erste Prüfwert im Betrieb des Steuerungssystems wiederholt berechnet wird. Bevorzugt wird der erste Prüfwert im Betrieb des Steuerungssystems in definierten Zeitintervallen berechnet. Des Weiteren ist es bevorzugt, wenn der Master für eine wiederholte Berechnung des ersten Prüfwertes den Startwert variiert. Diese Ausgestaltung ermöglicht eine einfache und schnelle Verifikation der konfigurierten Busteilnehmer im Betrieb des Bussystems, so dass beispielsweise eine Änderung aufgrund eines Speicherfehlers, einer Kabelquetschung oder aufgrund einer Änderung an den Busteilnehmern schnell erkannt werden kann. Diese Ausgestaltung trägt zu einer weiteren Erhöhung der Fehlersicherheit in vorteilhafter Weise bei.

In einer weiteren Ausgestaltung repräsentieren die Operanden ferner gerätespezifische Eigenschaften der Busteilnehmer, wie etwa eine Seriennummer, einen Gerätetyp und/oder einen Firmware-Stand der jeweiligen Busteilnehmer.

Mit dieser Ausgestaltung werden in vorteilhafter Weise nicht nur die vergebenen Teilnehmeradressen, sondern auch individuelle Eigenschaften der Busteilnehmer überwacht. Die Ausgestaltung trägt daher zu einer weiteren Erhöhung der Fehlersicherheit bei.

In einer weiteren Ausgestaltung wird der erste Prüfwert für eine Anzahl von Busteilnehmern berechnet, die kleiner oder größer ist als die Vielzahl der über das Kommunikationsmedium verbundenen Busteilnehmer.

In dieser Ausgestaltung wird der erste Prüfwert bewusst mit einer Anzahl von Busteilnehmern berechnet, die von der Anzahl der insgesamt zu verifizierenden Teilnehmeradressen abweicht. In bevorzugten Ausführungsbeispielen kann die Anzahl der zu verifizierenden Busteilnehmer individuell ausgewählt werden. Vorzugsweise erfolgt die Verifizierung für eine reduzierte Anzahl von Busteilnehmern nach einer Verifizierung aller vergebenen Adressen. Des Weiteren ist es von Vorteil, wenn die zu verifizierenden Busteilnehmer individuell ausgewählt werden können. Die Ausgestaltung ermöglicht eine gezielte und komfortable Diagnose für die Fälle, in denen eine Verifikation der vergebenen Teilnehmeradressen über die Vielzahl der Busteilnehmer hinweg scheitert. Da der erste Prüfwert von allen Busteilnehmern, deren Adressen verifiziert werden, gemeinsam berechnet wird, liefert das neue Verfahren zunächst einmal nur eine pauschale Aussage darüber, ob die Vergabe der Teilnehmeradressen insgesamt fehlerfrei funktioniert hat. Eine individuelle Fehleranalyse ist mit dem über alle Busteilnehmer berechneten Prüfwert jedoch schwierig. Durch eine gezielte Reduzierung der Anzahl der zu verifizierenden Busteilnehmer kann eine Fehlerquelle jedoch identifiziert werden. Des weiteren kann durch Verifikation einer eigentlich nicht vergebenen Teilnehmeradresse getestet werden, ob unerkannt noch weitere Busteilnehmer am Kommunikationsmedium angeschlossen sind. Die bevorzugte Ausgestaltung erleichtert also eine individuelle Diagnose.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine schematische Darstellung eines Ausführungsbeispiels des neuen Steuerungssystems;
- Fig. 2: ein Flussdiagramm zur Erläuterung eines bevorzugten Ausführungsbeispiels des neuen Verfahrens; und
- Fig. 3: das Steuerungssystem aus Fig. 1, wobei zwei Busteilnehmer vertauscht wurden.

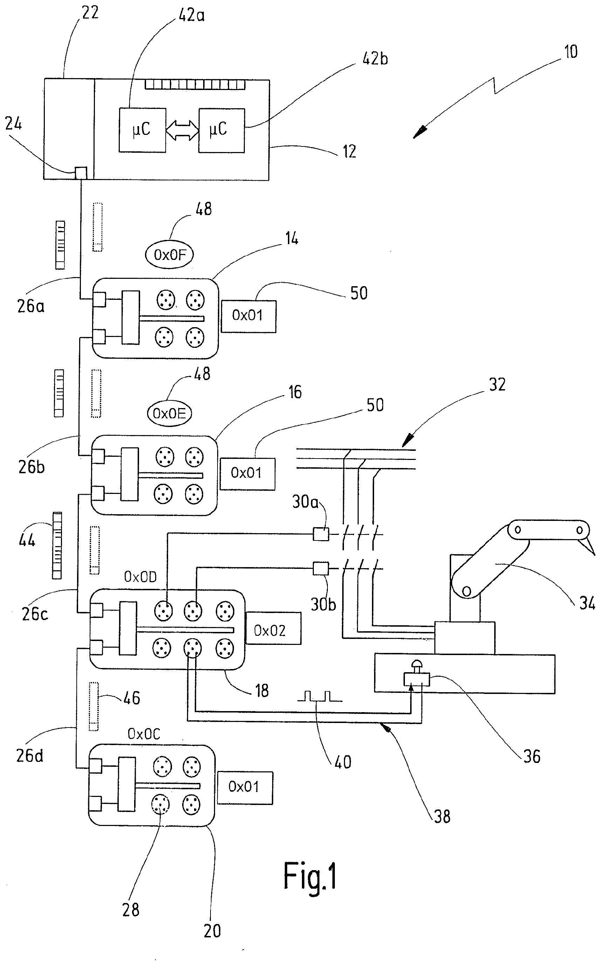

In Fig. 1 ist ein Steuerungssystem, bei dem das neue Verfahren implementiert ist, in seiner Gesamtheit mit der Bezugsziffer 10 bezeichnet. Das Steuerungssystem 10 beinhaltet eine Steuereinheit 12 und eine Anzahl E/A-Einheiten 14, 16, 18, 20. Die Steuereinheit 12 besitzt in diesem Fall ein integriertes oder angestecktes Busmodul 22 mit einer Busschnittstelle 24. An die Busschnittstelle 24 ist eine Busleitung 26a angeschlossen, die zu einer ersten Busschnittstelle 24 an der E/A-Einheit 14 führt. Die E/A-Einheit 14 besitzt eine zweite Busschnittstelle, von der eine weitere Busleitung 26b zu einer ersten Busschnittstelle der E/A-Einheit 16 führt. Von einer weiteren Busschnittstelle der E/A-Einheit 16 führt eine weitere Busleitung 26c zu einer ersten Busschnittstelle der E/A-Einheit 18. Von einer weiteren Busschnittstelle der E/A-Einheit 18 führt eine weitere Busleitung 26d zu einer ersten Busschnittstelle der E/A-Einheit 20. Die E/A-Einheiten 14 bis 20 sind also in einer Reihe an das Busmodul 22 der Steuereinheit 12 angeschlossen. Die Steuereinheit 12 mit dem Busmodul 22, die E/A-Einheiten 14 bis 20 und die Busleitungen 26a bis 26d bilden zusammen ein Bussystem, das Teil des Steuerungssystems 10 ist und das die Kommunikation zwischen der Steuereinheit 12 und den E/A-Einheiten ermöglicht. Dabei sind die E/A-Einheiten 14 bis 20 Busteilnehmer im Sinne der vorliegenden Erfindung. Die Steuereinheit 12 mit dem Busmodul 22 besitzt hier die Funktion eines Busmasters, über den auch die Vergabe und Verifikation von Teilnehmeradressen initiiert wird.

Die hier dargestellte Reihenanordnung der Busteilnehmer an einem Busmaster entspricht einem bevorzugten Ausführungsbeispiel. Die Erfindung ist jedoch darauf nicht beschränkt und kann gleichermaßen bei Bussystemen mit anderen Topologien, etwa einer Ring-, Stern- oder Baumtopologie, eingesetzt werden. Prinzipiell können das neue Verfahren und das neue Bussystem auch ohne Busmaster realisiert werden, beispielsweise also bei Bussystemen, bei denen die Busteilnehmer jederzeit senden und/oder empfangen können.

Jede E/A-Einheit 14 bis 20 besitzt eine Anzahl von Anschlussbuchsen zum Anschließen von Sensoren und/oder Aktoren. Beispielhaft ist an der E/A-Einheit 20 eine Anschlussbuchse mit der Bezugsziffer 28 bezeichnet.

An zwei Anschlussbuchsen der E/A-Einheit 18 sind hier beispielhaft zwei Schütze 30a, 30b angeschlossen. Die Schütze 30a, 30b sind Aktoren, mit denen das Steuerungssystem 10 Steuersignale zum Steuern eines technischen Prozesses erzeugt. Jeder Schütz 30a, 30b besitzt eine Anzahl von Schließerkontakten. Jeweils ein Schließerkontakt von jedem Schütz 30a, 30b ist in Reihe zwischen einer Stromversorgung 32 und einer zu steuernden Anlage 34 angeordnet. Beispielhaft ist die Anlage 34 hier ein Roboter dargestellt. Mit Hilfe der Schütze 30a, 30b kann der Roboter 34 von der Stromversorgung 32 getrennt werden.

Mit der Bezugsziffer 36 ist ein Not-Aus-Taster bezeichnet, der über ein Leitungspaar 38 an eine weitere Anschlussbuchse der E/A-Einheit 18 angeschlossen ist. Die E/A-Einheit 18 erzeugt auf einer Hinleitung zum Not-Aus-Taster 36 ein Taktsignal 40 mit einer definierten Taktperiode. Das Taktsignal 40 ist über den Not-Aus-Taster 36 und eine Rückleitung des Leitungspaars 38 zu der E/A-Einheit 18 zurückgeführt. Der Not-Aus-Taster 36 ist ein bevorzugtes Beispiel für ein Meldegerät bzw. einen Sensor, der ein Eingangssignal liefert, das von der Steuereinheit 12 ausgewertet wird. In Abhängigkeit von dem Eingangssignal erzeugt die Steuereinheit 12 die Steuersignale für die Schütze 30a, 30b.

Die Schütze 30a, 30b und der Not-Aus-Taster 36 sind hier Beispiele von Aktoren und Sensoren. Andere bevorzugte Sensoren sind Sicherheitslichtschranken, Schutztürschalter, Zwei-Hand-Schalter oder auch Sensoren, die Größen wie Temperatur, Druck, Position, Geschwindigkeit etc. messen. Als Aktoren können darüber hinaus Magnetventile, elektrische Antriebe und anderes an die E/A-Einheiten 14 bis 20 angeschlossen werden.

In Fig. 1 ist der Einfachheit halber nur ein Steuerungssystem 10 zum Absichern des Roboters 34 gezeigt, nicht jedoch ein Steuerungssystem, das den Arbeitsbetrieb des Roboters 34 steuert. Prinzipiell können beide Steuerungssysteme identisch sein, d.h. das Steuerungssystem 10 steuert sowohl den Betriebsablauf als auch die sicherheitsrelevanten Überwachungsfunktionen. In vielen Fällen wird jedoch bis heute für die Sicherheitsfunktionen ein separates Steuerungssystem verwendet, da die Anforderungen an die Eigenfehlersicherheit des Steuerungssystems im Hinblick auf die Sicherheitsfunktionen wesentlich höher sind als im Hinblick auf die Steuerung der Betriebsabläufe. Andererseits erfordert die Steuerung eines Betriebsablaufs häufig eine höhere Rechenleistung als die Steuerung der Sicherheitsfunktionen.

Zum Steuern der Sicherheitsfunktionen ist die Steuereinheit 12 typischerweise mehrkanalig-redundant aufgebaut, was in Fig. 1 symbolisch anhand von zwei Mikroprozessoren 42a, 42b dargestellt ist, die sich gegenseitig überwachen und/oder ihre Ergebnisse austauschen. Anstelle von Mikroprozessoren können auch andere programmierbaren Logikschaltkreise verwendet sein, wie Mikrocontroller, FPGAs, ASICs und anderes. In einigen bevorzugten Ausführungsbeispielen führen die programmierbaren Schaltkreise 42a, 42b eine redundante Berechnung des (zweiten) Prüfwertes durch, mit dessen Hilfe die Vergabe von Teilnehmeradressen an die E/A-Einheiten 14 bis 20 nach dem neuen Verfahren fehlersicher verifiziert wird.

Die Steuereinheit 12 kommuniziert mit den E/A-Einheiten 14 bis 20, indem sie über das Busmodul 22 Datentelegramme 44 versendet und von den E/A-Einheiten 14 bis 20 Antworttelegramme 46 empfängt. In einem bevorzugten Ausführungsbeispiel erfolgt der Austausch der Daten- und Antworttelegramme nach einem Verfahren, wie es in DE 10 2008 060 007 A1 beschrieben ist. Das neue Verfahren zur Verifikation von Teilnehmeradressen ist jedoch nicht auf das bevorzugte Datenübertragungsverfahren beschränkt und kann auch bei anderen Busprotokollen verwendet werden, bei denen Teilnehmeradressen zur Anwendung kommen.

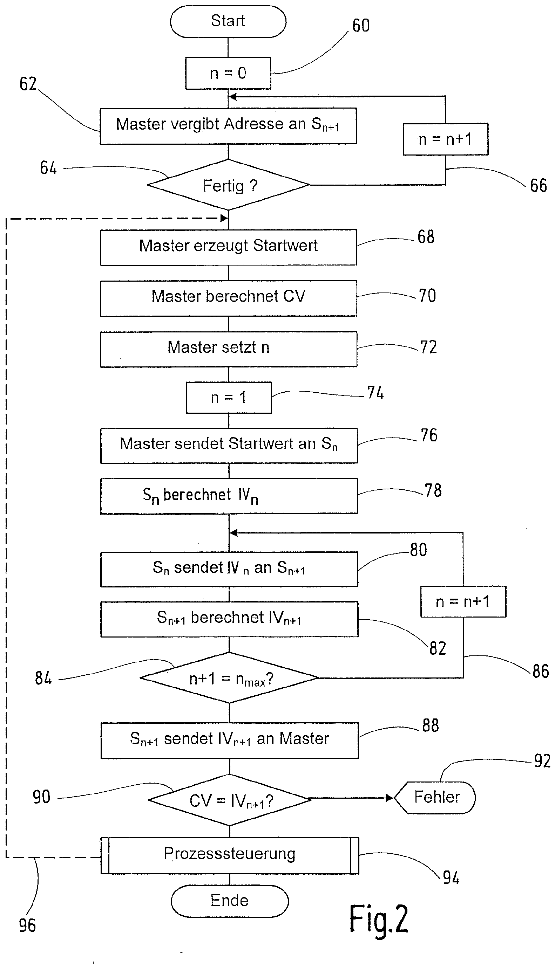

Im vorliegenden Fall erhalten die E/A-Einheiten 14 bis 20 jeweils eine individuelle Teilnehmeradresse 48 von der Steuereinheit 12. Beispielhaft ist der E/A-Einheit 14 hier eine Teilnehmeradresse 0x0F zugewiesen, der E/A-Einheit 16 ist eine Teilnehmeradresse 0x0E zugewiesen, der E/A-Einheit 18 ist eine Teilnehmeradresse 0x0D zugewiesen, und der E/A-Einheit 20 ist eine Teilnehmeradresse 0x0C zugewiesen. Die Zuweisung der Adressen erfolgt in bevorzugten Ausführungsbeispielen in einem Konfigurationsmodus vor der Inbetriebnahme des Steuerungssystems 10, indem die Steuereinheit 12 Datentelegramme 44 über die Busschnittstelle 24 versendet, in denen jeweils eine Teilnehmeradresse 48 enthalten ist. Jede E/A-Einheit, die bereits eine Teilnehmeradresse zugewiesen bekommen hat, leitet ein solches Datentelegramm an die nächste E/A-Einheit in der Reihenanordnung weiter. Eine E/A-Einheit, die noch keine Adresse zugewiesen bekommen hat, entnimmt die in einem solchen Datentelegramm enthaltene Adresse als zugewiesene Adresse. Somit können die E/A-Einheiten 14 bis 20 von der Steuereinheit 12 der Reihe nach "getauft" werden. Anschließend verifiziert die Steuereinheit 12 die vergebenen Teilnehmeradressen nach einem Verfahren, wie es nachfolgend anhand Fig. 2 erläutert wird.

Bei der Bezugsziffer 50 sind hier noch spezielle Teilnehmerdaten angedeutet, die für den jeweiligen Busteilnehmer 14, 16, 18, 20 repräsentativ sind. beispielsweise handelt es sich um eine individuelle Seriennummer, eine Gerätetypnummer, einen Firmwarestand u.a.. Im dargestellten Ausführungsbeispiel besitzen die Busteilnehmer 14, 16 und 20 die Gerätetypnummer 0x01, während der Busteilnehmer 18 die Gerätetypnummer 0x02 hat.

Gemäß Fig. 2 wird im Schritt 60 zunächst eine Zählvariable n = 0 gesetzt. Gemäß Schritt 62 vergibt der Busmaster, in diesem Fall also die Steuereinheit 12, anschließend eine Teilnehmeradresse an einen ersten Busteilnehmer, der in Fig. 2 allgemein als Sₙ₊₁ bezeichnet ist. Für das Steuerungssystem 10 gemäß Fig. 1 ist der erste Busteilnehmer die E/A-Einheit 14, die von der Steuereinheit 12 die Teilnehmeradresse 0x0F erhält. Im Schritt 64 erfolgt eine Abfrage, ob weitere Adressen an weitere Busteilnehmer zu vergeben sind. Wenn dies der Fall ist, kehrt das Verfahren gemäß Schleife 66 zu Schritt 62 zurück, wobei die Zählvariable n um 1 inkrementiert wird.

Wenn alle Teilnehmeradressen vergeben sind, beginnt die bevorzugte Verifikation, indem der Busmaster gemäß Schritt 68 einen Startwert erzeugt. In bevorzugten Ausführungsbeispielen ist der Startwert ein Zahlenwert aus einem Zahlenraum, aus dem auch die vergebenen Teilnehmeradressen stammen. Beispielhaft sei angenommen, dass der Startwert hier 0x7A ist.

Des Weiteren sei beispielhaft angenommen, dass der Master als mathematische Operation eine CRC-8-Prüfsummenberechnung mit dem Generatorpolynom x⁸+x⁵+x⁴+x¹ verwendet. Der Master berechnet also die CRC-8 mit dem Startwert 0x7A über die Daten (Teilnehmeradressen) 0x0F, 0x0E, 0x0D und 0x0C. Das Ergebnis ist der Prüfwert CV = 0xF7. Eine nähere Beschreibung des CRC-8- Prüfsummenalgorithmus findet sich in der einschlägigen Fachliteratur sowie beispielsweise in Wikipedia unter der Adresse http://en.wikidedia.org/wiki/Cyclic_redundancy_check.

In Schritt 72 setzt der Master einen Wert nₘₐₓ, der die Anzahl der zu verifizierenden Teilnehmeradressen spezifiziert. Durch Wahl eines Wertes, der kleiner ist als die Anzahl der insgesamt an das Bussystem 10 angeschlossenen Busteilnehmer, kann der Master die Verifikation auf eine reduzierte Anzahl von Busteilnehmern begrenzen. Zunächst sei angenommen, dass der Master nₘₐₓ = 4 setzt, d.h. er führt die Verifikation über alle E/A-Einheiten 14 bis 20 durch.

Im nächsten Schritt 74 wird erneut eine Zählvariable n = 1 gesetzt. Anschließend sendet der Master gemäß Schritt 76 den Startwert 0x7A an den Busteilnehmer S₁, d.h. die E/A-Einheit 14. Der Busteilnehmer S₁ berechnet einen ersten Zwischenwert IV₁, indem er mit dem Startwert 0x7a eine CRC-8-Prüfsumme zu seiner eigenen Adresse 0x0F berechnet. Das Zwischenergebnis IV₁ ist in diesem Fall 0x0D.

Gemäß Schritt 80 sendet der Busteilnehmer S₁ den ersten Zwischenwert IV₁ an den nächsten Busteilnehmer S₂. Dieser berechnet einen weiteren Zwischenwert IVₙ₊₁, indem er den empfangenen Zwischenwert IV₁ = 0x0D als Startwert verwendet und seine eigene Adresse 0x0E als Operand. Der zweite Zwischenwert IV₂ ist in diesem Fall 0x53.

Gemäß Schritt 84 prüft der zweite Busteilnehmer, ob er der letzte in der Reihe der zu verifizierenden Busteilnehmer ist. Im vorliegenden Fall folgen jedoch noch zwei Busteilnehmer (E/A-Einheiten 18 und 20), so dass gemäß Schleife 86 zwei weitere Operationsschritte in den beiden weiteren Busteilnehmern 18 und durchgeführt werden. Im angenommenen Beispiel erhält der dritte Busteilnehmer (E/A-Einheit 18) den zweiten Zwischenwert IV₂ = 0x53 als Startwert, und er berechnet mit seiner eigenen Teilnehmeradresse 0x0D einen dritten Zwischenwert IV₃ = 0x61. Der vierte Busteilnehmer (E/A-Einheit 20) empfängt den Zwischenwert IV₃ = 0x61 als Startwert und berechnet mit seiner Teilnehmeradresse 0x0C einen weiteren Zwischenwert IV₄ = 0xF7. Da kein weiterer Busteilnehmer in der Reihe folgt, sendet die E/A-Einheit 20 den Zwischenwert IV₄ als ersten Prüfwert an den Busmaster 12 zurück (Schritt 88).

Der Busmaster bzw. die Steuereinheit 12 prüft gemäß Schritt 90, ob der empfangene Prüfwert IV₄ gleich dem zuvor berechneten Prüfwert CV ist. Weichen die beiden Prüfwerte voneinander ab, liegt ein Fehler bei der Adressvergabe und/oder Verifizierung vor. Dementsprechend erzeugt die Steuereinheit 12 gemäß Schritt 92 ein Fehlersignal. Sind die beiden Prüfwerte hingegen identisch, ist dies ein Indiz dafür, dass die Adresszuweisung fehlerfrei erfolgt ist. Das Steuerungssystem 10 kann nun in den Steuerungsbetrieb übergehen, was mit Schritt 94 angedeutet ist.

In bevorzugten Ausführungsbeispielen wird die Verifikation der vergebenen Adressen während der Prozesssteuerung zu definierten Zeitpunkten wiederholt, was mit der Schleife 96 angedeutet ist.

In einer Variante dieses Ausführungsbeispiels werden nicht nur die zuvor vergebenen Teilnehmeradressen, sondern auch die teilnehmerspezifischen Daten 50 in die Verifikation einbezogen. Die Steuereinheit 12 berechnet nun den Prüfwert CV über die Teilnehmeradressen und Typencodes 0x0F, 0x01, 0x0E, 0x01, 0x0D, 0x02, 0x0C, 0x01 und erhält als Ergebnis den Prüfwert CV = 0x62.

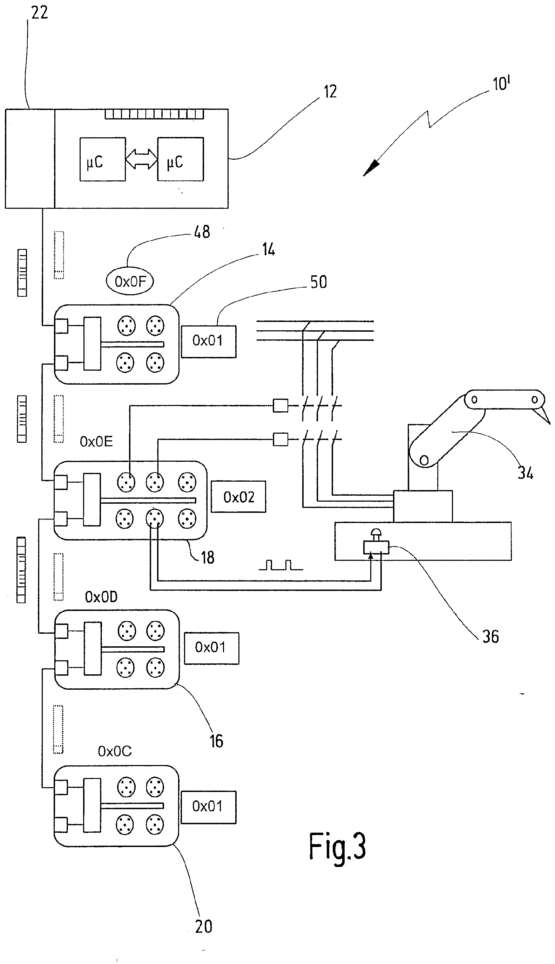

Nun sei angenommen, dass die E/A-Einheiten 16 und 18 nachträglich vertauscht wurden, wie dies in Fig. 3 dargestellt ist. Die E/A-Einheit 14 empfängt nun den Startwert 0x7A und berechnet mit der eigenen Adresse 0x0F und dem Gerätetyp 0x01 einen ersten Zwischenwert IV₁ = 0x7D. Die (vertauschte) E/A-Einheit 18 berechnet nun als zweiter Busteilnehmer mit dem Startwert 0x7D, der zugewiesenen Adresse 0x0E und dem Gerätetyp 0x02 den zweiten Zwischenwert IV₂ = 0x74.

Die dritte E/A-Einheit berechnet mit dem Startwert 0x74, der zugewiesenen Adresse 0x0D und dem Gerätetyp 0x01 den dritten Zwischenwert IV₃ = 0xC9. Die vierte E/A-Einheit berechnet mit dem Startwert 0xC9, der zugewiesenen Adresse 0x0C und dem Gerätetyp 0x01 den vierten Zwischenwert 0xEC und sendet dieses Ergebnis als (ersten) Prüfwert an den Busmaster zurück. Der Vergleich der beiden Prüfwerte CV = 0x62 und IV₄ = 0xEC zeigt an, dass die tatsächliche Konfiguration nicht mit der erwarteten Konfiguration übereinstimmt, obwohl die Vergabe der Adressen für sich genommen erfolgreich war.

Wie bereits zuvor in Bezug auf Fig. 2 erwähnt, kann die Steuereinheit 12 den falsch konfigurierten Busteilnehmer identifizieren, indem sie den Verifikationsablauf zunächst nur bis zu der ersten E/A-Einheit 14 durchführt und dann schrittweise um jeweils eine weitere E/A-Einheit erweitert. Sobald sie zu der vertauschten E/A-Einheit 18 kommt, weichen die beiden Prüfwerte voneinander ab. Des weiteren kann die Steuereinheit 12 einen Verifikationsdurchlauf für eine Anzahl von Busteilnehmern initiieren, die größer ist als die Zahl der Busteilnehmer in der Sollkonfiguration, und/oder sie kann gezielt eine eigentlich nicht vergebene Teilnehmeradresse in dem Verifikationsdurchlauf ansprechen, um auf diese Weise zu überprüfen, ob mehr Busteilnehmer am Kommunikationsmedium angeschlossen sind, als vorgesehen. Dies ist besonders vorteilhaft, um zu überprüfen, ob ein Busteilnehmer, der laut Sollkonfiguration vom Kommunikationsmedium entfernt wurde, tatsächlich auch fehlt.

In einer Variante des zuvor beschriebenen Ausführungsbeispiels verwendet das neue Verfahren eine CRC-16-Prüfsummenberechnung, wobei die Adresse und der Typencode jedes Busteilnehmers zu einem 16-Bit-Datenwert zusammengefasst werden. Prinzipiell sind auch andere mathematische Operationen für das neue Verfahren geeignet, die in mehreren sequentiellen Schritten durchgeführt werden und somit auf eine Anzahl von Busteilnehmern verteilt werden können, und die ein eindeutiges Ergebnis in Abhängigkeit von den verwendeten Operanden und - bevorzugt - in Abhängigkeit von der Reihenfolge der durchgeführten Operationsschritte liefern.

## Patentansprüche

1. Verfahren zur Vergabe von Teilnehmeradressen (48) an Busteilnehmer (14, 16, 18, 20) eines busbasiertes Steuerungssystems (10), insbesondere eines busbasiertes Steuerungssystems zum automatisierten Steuern eines technischen Prozesses (34), mit den Schritten:
- Bereitstellen einer Vielzahl von Busteilnehmern (14, 16, 18, 20), die über ein Kommunikationsmedium (26) miteinander verbunden werden,
- Zuweisen von logischen Teilnehmeradressen (48) an die Busteilnehmer (14, 16, 18, 20) von einer zentralen Station (12) aus, und
- Verifizieren der zugewiesenen logischen Teilnehmeradressen (48) in der zentralen Station (12),
**dadurch gekennzeichnet, dass** die Busteilnehmer (14, 16, 18, 20) mit Hilfe einer definierten mathematischen Operation (78-86) einen gemeinsamen ersten Prüfwert (IVₙ₊₁) berechnen, der in der zentralen Station (12) mit einem zweiten Prüfwert (CV) verglichen wird (90), um die zugewiesenen logischen Teilnehmeradressen (48) zu verifizieren, wobei die mathematische Operation mit einem definierten Startwert (68) beginnt und eine Anzahl von Operationsschritten (78, 82) beinhaltet, die eine Anzahl von definierten Operanden verwenden,
wobei jede der zu verifizierenden Teilnehmeradressen (48) einen anderen Operanden bildet,
wobei jeder Busteilnehmer (14, 16, 18, 20) zumindest einen Operationsschritt durchführt,
wobei die zentrale Station (12) über das Kommunikationsmedium (26) mit den Busteilnehmern (14, 16, 18, 20) verbunden ist und den gemeinsamen ersten Prüfwert (IVₙ₊₁) über das Kommunikationsmedium (26) erhält, und
wobei die zentrale Station (12) den zweiten Prüfwert (CV) unabhängig von den Busteilnehmern (14, 16, 18, 20) mit derselben mathematischen Operation, demselben Startwert und denselben Operanden berechnet.

2. Verfahren nach Anspruch 1, **dadurch gekennzeichnet, dass** jeder Busteilnehmer (14, 16, 18, 20) einen Operationsschritt durchführt, in dem die dem Busteilnehmer zugewiesene Teilnehmeradresse (48) den Operand bildet.

3. Verfahren nach Anspruch 1 oder 2, **dadurch gekennzeichnet, dass** die zentrale Station (12) fehlersicher ausgebildet ist.

4. Verfahren nach einem der Ansprüche 1 bis 3, **dadurch gekennzeichnet, dass** die Busteilnehmer (14, 16, 18, 20) in einer logischen Reihenfolge über das Kommunikationsmedium (26) verbunden werden, wobei die logische Reihenfolge einen ersten Busteilnehmer (14), zumindest einen zweiten Busteilnehmer (16, 18) und einen letzten Busteilnehmer (20) aufweist.

5. Verfahren nach Anspruch 4, **dadurch gekennzeichnet, dass** der erste Busteilnehmer (14) einen ersten Operationsschritt (78) durchführt, der den Startwert und einen ersten Operanden verwendet, um einen ersten Zwischenwert (IVₙ) zu bestimmen, wobei der erste Busteilnehmer (14) den ersten Zwischenwert (IVₙ) an den zweiten Busteilnehmer (16, 18) sendet, und wobei der zweite Busteilnehmer (16, 18) einen zweiten Operationsschritt (82) durchführt, in dem der erste Zwischenwert und ein zweiter Operand verwendet werden, um einen zweiten Zwischenwert (IVₙ₊₁) zu bestimmen.

6. Verfahren nach Anspruch 5, **dadurch gekennzeichnet, dass** der letzte Busteilnehmer (20) den gemeinsamen ersten Prüfwert (IVₙ₊₁) mit dem letzten Operationsschritt berechnet.

7. Verfahren nach Anspruch 5, **dadurch gekennzeichnet, dass** der letzte Busteilnehmer mit dem letzten Operationsschritt einen weiteren Zwischenwert bestimmt, mit dem der erste Prüfwert in weiteren Operationsschritten berechnet wird.

8. Verfahren nach einem der Ansprüche 1 bis 7, **dadurch gekennzeichnet, dass** die Operationsschritte in einer definierten Reihenfolge von Operationsschritten durchgeführt werden, wobei der erste Prüfwert in Abhängigkeit von der definierten Reihenfolge von Operationsschritten variiert.

9. Verfahren nach einem der Ansprüche 1 bis 8, **dadurch gekennzeichnet, dass** die mathematische Operation eine Prüfsummenberechnung, insbesondere eine CRC-Prüfsummenberechnung ist.

10. Verfahren nach einem der Ansprüche 1 bis 9, **dadurch gekennzeichnet, dass** das Steuerungssystem (10) nach einer erfolgreichen Verifikation in Betrieb (94) genommen wird, wobei der erste Prüfwert im Betrieb des Steuerungssystems (10) wiederholt (96) berechnet wird.

11. Verfahren nach einem der Ansprüche 1 bis 10, **dadurch gekennzeichnet, dass** die Operanden ferner gerätespezifische Eigenschaften (50) der Busteilnehmer (14, 16, 18, 20) repräsentieren.

12. Verfahren nach einem der Ansprüche 1 bis 11, **dadurch gekennzeichnet, dass** der erste Prüfwert (IVₙ₊₁) für eine Anzahl von Busteilnehmern (14, 16, 18, 20) berechnet wird, die kleiner oder größer ist als die Vielzahl der über das Kommunikationsmedium (26) verbundenen Busteilnehmer (14, 16, 18, 20).

13. Steuerungssystem zum automatisierten Steuern eines technischen Prozesses, mit einer Vielzahl von Busteilnehmern (14, 16, 18, 20), die über ein Kommunikationsmedium (26) miteinander verbunden sind, wobei den Busteilnehmern (14, 16, 18, 20) logische Teilnehmeradressen (48) zugewiesen sind, und mit einer Station (12), die dazu ausgebildet ist, die zugewiesenen logischen Teilnehmeradressen (48) zu verifizieren, **dadurch gekennzeichnet, dass** die Busteilnehmer (14, 16, 18, 20) dazu ausgebildet sind, mit Hilfe einer definierten mathematischen Operation einen gemeinsamen ersten Prüfwert (IVₙ₊₁) zu berechnen, der in der Station (12) mit einem zweiten Prüfwert (CV) verglichen wird, um die zugewiesenen logischen Teilnehmeradressen (48) zu verifizieren, wobei die mathematische Operation mit einem definierten Startwert (68) beginnt und eine Anzahl von Operationsschritten (78-86) beinhaltet, die eine Anzahl von definierten Operanden verwenden, wobei jede der zu verifizierenden Teilnehmeradressen (48) einen anderen Operanden bildet, wobei jeder Busteilnehmer (14, 16, 18, 20) dazu ausgebildet ist, zumindest einen Operationsschritt durchzuführen, wobei die Station (12) über das Kommunikationsmedium (26) mit den Busteilnehmern (14, 16, 18, 20) verbunden ist und den gemeinsamen ersten Prüfwert (IVₙ₊₁) über das Kommunikationsmedium (26) erhält, und wobei die Station (12) den zweiten Prüfwert (CV) unabhängig von den Busteilnehmern (14, 16, 18, 20) mit derselben mathematischen Operation, demselben Startwert und denselben Operanden berechnet.

## Claims

1. A method for allocating subscriber addresses (48) to bus subscribers (14, 16, 18, 20) in a bus-based control system (10), particularly a bus-based control system for the automated control of a technical process (34), the method comprising the following steps:
- providing a plurality of bus subscribers (14, 16, 18, 20) which are connected to one another by means of a communication medium (26),
- assigning logical subscriber addresses (48) to the bus subscribers (14, 16, 18, 20) from a central station (12), and
- verifying the assigned logical subscriber addresses (48) in the central station (12),
**characterized in that** the bus subscribers (14, 16, 18, 20) use a defined mathematical operation (78-86) to calculate a common first check value (IVₙ₊₁) which is compared (90) with a second check value (CV) in the central station (12) in order to verify the assigned logical subscriber addresses (48), wherein the mathematical operation begins with a defined starting value (68) and comprises a number of operation steps (78, 82) which use a number of defined operands,
wherein each of the subscriber addresses (48) to be verified forms a different operand,
wherein each bus subscriber (14, 16, 18, 20) executes at least one operation step
wherein the central station (12) is connected to the bus subscribers (14, 16, 18, 20) by means of the communication medium (26) and obtains the common first check value (IVₙ₊₁) via the communication medium (26), and
wherein the central station (12) calculates the second check value (CV) independently of the bus subscribers (14, 16, 18, 20) using the same mathematical operation, the same starting value and the same operands.

2. The method of claim 1, **characterized in that** each bus subscriber (14, 16, 18, 20) executes an operation step in which the subscriber address (48) assigned to said bus subscriber forms the operand.

3. The method of claim 1 or 2, **characterized in that** the central station (12) is of failsafe design.

4. The method of one of claims 1 to 3, **characterized in that** the bus subscribers (14, 16, 18, 20) are connected in a logical order by means of the communication medium (26), wherein the logical order has a first bus subscriber (14), at least one second bus subscriber (16, 18) and a last bus subscriber (20).

5. The method of claim 4, **characterized in that** the first bus subscriber (14) executes a first operation step (78) which uses the starting value and a first operand in order to determine a first intermediate value (IVₙ), wherein the first bus subscriber (14) sends the first intermediate value (IVₙ) to the second bus subscriber (16, 18), and wherein the second bus subscriber (16, 18) executes a second operation step (82) in which the first intermediate value and a second operand are used in order to determine a second intermediate value (IVₙ₊₁).

6. The method of claim 5, **characterized in that** the last bus subscriber (20) calculates the common first check value (IVₙ₊₁) using the last operation step.

7. The method of claim 5, **characterized in that** the last bus subscriber uses the last operation step to determine a further intermediate value which is used to calculate the first check value in further operation steps.

8. The method of one of claims 1 to 7, **characterized in that** the operation steps are executed in a defined order of operation steps, wherein the first check value varies depending on the defined order of operation steps.

9. The method of one of claims 1 to 8, **characterized in that** the mathematical operation is a checksum calculation, particularly a CRC checksum calculation.

10. The method of one of claims 1 to 9, **characterized in that** the control system (10) is put into operation (94) following successful verification, wherein the first check value is calculated repeatedly (96) during the operation of the control system (10).

11. The method of one of claims 1 to 10, **characterized in that** the operands further represent device-specific properties (50) of the bus subscribers (14, 16, 18, 20).

12. The method of one of claims 1 to 11, **characterized in that** the first check value (IVₙ₊₁) is calculated for a number of bus subscribers (14, 16, 18, 20) which is smaller or greater than the number of the bus subscribers (14, 16, 18, 20) which are connected by means of the communication medium (26).

13. A control system for the automated control of a technical process, comprising a plurality of bus subscribers (14, 16, 18, 20) which are connected to one another by means of a communication medium (26), wherein the bus subscribers (14, 16, 18, 20) have assigned logical subscriber addresses (48), and comprising a station (12) designed to verify the assigned logical subscriber addresses (48), **characterized in that** the bus subscribers (14, 16, 18, 20) are designed to use a defined mathematical operation to calculate a common first check value (IVₙ₊₁) which is compared in the station (12) with a second check value (CV) in order to verify the assigned logical subscriber addresses (48), wherein the mathematical operation begins with a defined starting value (68) and comprises a number of operation steps (78-86) which use a number of defined operands, wherein each of the subscriber addresses (48) to be verified forms a different operand, wherein each bus subscriber (14, 16, 18, 20) is designed to perform at least one operation step, wherein the station (12) is connected to the bus subscribers (14, 16, 18, 20) by means of the communication medium (26) and obtains the common first check value (IVₙ₊₁) via the communication medium (26), and wherein the station (12) calculates the second check value (CV) independently of the bus subscribers (14, 16, 18, 20) using the same mathematical operation, the same starting value and the same operands.

## Revendications

1. Procédé d'attribution d'adresses d'abonnés (48) à des abonnés à un bus (14, 16, 18, 20) d'un système de commande à base de bus (10), en particulier d'un système de commande à base de bus destiné à commander de manière automatisée un processus technique (34), comprenant les étapes suivantes :
- la fourniture d'une pluralité d'abonnés au bus (14, 16, 18, 20) qui sont reliés entre eux par l'intermédiaire d'un support de communication (26),
- l'assignation d'adresses logiques d'abonnés (48) aux abonnés au bus (14, 16, 18, 20) par une station centrale (12), et
- la vérification des adresses logiques d'abonnés (48) assignées dans la station centrale (12),
**caractérisé en ce que** les abonnés au bus (14, 16, 18, 20) calculent, à l'aide d'une opération mathématique définie (78-86), une première valeur de contrôle (IVn+1) commune qui est comparée (90) à une seconde valeur de contrôle (CV) dans la station centrale (12), afin de vérifier les adresses logiques d'abonnés (48) assignées, dans lequel l'opération mathématique commence par une valeur initiale définie (68) et comprend un certain nombre d'étapes d'opération (78, 82) qui utilisent un certain nombre d'opérandes, dans lequel chacune des adresses d'abonnés (48) à vérifier constitue un opérande différent,
dans lequel chaque abonné au bus (14, 16, 18, 20) effectue au moins une étape d'opération,
dans lequel la station centrale (12) est reliée aux abonnés au bus (14, 16, 18, 20) par l'intermédiaire du support de communication (26) et reçoit la première valeur de contrôle (IVn+1) commune par l'intermédiaire du support de communication (26), et
dans lequel la station centrale (12) calcule la seconde valeur de contrôle (CV) indépendamment des abonnés au bus (14, 16, 18, 20) au moyen de la même opération mathématique, de la même valeur initiale et des mêmes opérandes.

2. Procédé selon la revendication 1, **caractérisé en ce que** chaque abonné au bus (14, 16, 18, 20) effectue une étape d'opération lors de laquelle l'adresse d'abonné (48) assignée à l'abonné au bus constitue l'opérande.

3. Procédé selon la revendication 1 ou 2, **caractérisé en ce que** la station centrale (12) est conçue pour être du type à sécurité intégrée.

4. Procédé selon l'une des revendications 1 à 3, **caractérisé en ce que** les abonnés au bus (14, 16, 18, 20) sont reliés selon une séquence logique par l'intermédiaire du support de communication (26), dans lequel la séquence logique comprend un premier abonné au bus (14), au moins un second abonné au bus (16, 18) et un dernier abonné au bus (20).

5. Procédé selon la revendication 4, **caractérisé en ce que** le premier abonné au bus (14) effectue une première étape d'opération (78) qui utilise la valeur initiale et un premier opérande pour déterminer une première valeur intermédiaire (IVn), dans lequel le premier abonné au bus (14) envoie la première valeur intermédiaire (IVn) au second abonné au bus (16, 18), et dans lequel le second abonné au bus (16, 18) effectue une seconde étape d'opération (82) lors de laquelle la première valeur intermédiaire et un second opérande sont utilisés pour déterminer une seconde valeur intermédiaire (IVn+1).

6. Procédé selon la revendication 5, **caractérisé en ce que** le dernier abonné au bus (20) calcule la première valeur de contrôle (IVn+1) commune au moyen de la dernière étape d'opération.

7. Procédé selon la revendication 5, **caractérisé en ce que** le dernier abonné au bus détermine une autre valeur intermédiaire au moyen de la dernière étape d'opération, avec laquelle la première valeur de contrôle est calculée lors d'autres étapes d'opération.

8. Procédé selon l'une des revendications 1 à 7, **caractérisé en ce que** les étapes d'opération sont effectuées selon une séquence définie d'étapes d'opération, dans lequel la première valeur de contrôle varie en fonction de la séquence définie d'étapes d'opération.

9. Procédé selon l'une des revendications 1 à 8, **caractérisé en ce que** l'opération mathématique est un calcul de total de contrôle, en particulier un calcul de total de contrôle CRC.

10. Procédé selon l'une des revendications 1 à 9, **caractérisé en ce que** le système de commande (10) est mis en service (94) après une vérification réussie, dans lequel la première valeur de contrôle est calculée de manière répétée (96) pendant le fonctionnement du système de commande (10).

11. Procédé selon l'une des revendications 1 à 10, **caractérisé en ce que** les opérandes représentent en outre des propriétés propres à l'appareil (50) des abonnés au bus (14, 16, 18, 20).

12. Procédé selon l'une des revendications 1 à 11, **caractérisé en ce que** la première valeur de contrôle (IVn+1) est calculée pour un nombre d'abonnés au bus (14, 16, 18, 20) qui est inférieur ou supérieur à celui de la pluralité des abonnés au bus (14, 16, 18, 20) reliés par l'intermédiaire du support de communication (26).

13. Système de commande destiné à commander de manière automatisée un processus technique, comprenant une pluralité d'abonnés à un bus (14, 16, 18, 20) qui sont reliés entre eux par l'intermédiaire d'un support de communication (26), dans lequel des adresses logiques d'abonnés (48) sont assignées aux abonnés au bus (14, 16, 18, 20), et comprenant une station (12) qui est conçue pour vérifier les adresses logiques d'abonnés (48) assignées, **caractérisé en ce que** les abonnés au bus (14, 16, 18, 20) sont conçus pour calculer, à l'aide d'une opération mathématique définie, une première valeur de contrôle (IVn+1) commune qui est comparée dans la station (12) à une seconde valeur de contrôle (CV), afin de vérifier les adresses logiques d'abonnés assignées (48), dans lequel l'opération mathématique commence par une valeur initiale définie (68) et comprend une pluralité d'opérations (78-86) qui utilisent une pluralité d'opérandes définis, dans lequel chacune des adresses d'abonnés (48) à vérifier constitue un opérande différent, dans lequel chaque abonné au bus (14, 16, 18, 20) est conçu pour effectuer au moins une étape d'opération, dans lequel la station (12) est reliée aux abonnés au bus (14, 16, 18, 20) par l'intermédiaire du support de communication (26) et reçoit la première valeur de contrôle (IVn+1) commune par l'intermédiaire du support de communication (26), et dans lequel la station (12) calcule la seconde valeur de contrôle (CV) indépendamment des abonnés au bus (14, 16, 18, 20) au moyen de la même opération mathématique, de la même valeur initiale et des mêmes opérandes.
